# DEMANDE DE BREVET EUROPEEN

(11) **EP 1 113 494 A1**
(43) Date de publication de la demande: **04.07.2001**
(21) Numéro de dépôt: 00403692.7
(22) Date de dépôt: 27.12.2000
(51) Int. Cl.: H01L 21/8247, H01L 27/02

(54) **Dispositif de protection de lignes d'interconnexions dans un circuit intégré**

(30) Priorité: 28.12.1999 FR 9916604
(71) Demandeur: STMicroelectronics SA, 94250 Gentilly (FR)
(72) Inventeur: Tailliet, François, 94230 Cachan (FR)
(74) Mandataire: Ballot, Paul

(57) **Abrégé**

Un dispositif de protection 1 d'une ligne d'interconnexion Li d'un circuit intégré, comprend un dispositif d'écoulement de charges M1 connecté entre la ligne d'interconnexion à protéger et le substrat du circuit intégré et une ligne d'interconnexion témoin ANT pour déclencher le dispositif d'écoulement, le dispositif de protection étant actif au long de la fabrication du circuit intégré.

## Description

La présente invention concerne un dispositif de protection de lignes d'interconnexions dans un circuit intégré, pour protéger des éléments connectés à ces lignes contre des charges électrostatiques engendrées sur ces lignes pendant la fabrication du circuit intégré.

Elle s'applique notamment aux circuits intégrés comprenant des mémoires en technologie MOS, qui peuvent être de différents types, par exemple, DRAM, NVRAM, EPROM, EEPROM, ou encore FLASH EPROM.

Selon l'architecture habituelle, matricielle, des mémoires, chaque cellule est commandée par une ligne de bit et une ligne de mot de la mémoire. Les lignes de mot et les lignes de bit sont pilotées par les sorties d'un décodeur. Chaque cellule peut ainsi être lue ou écrite individuellement, par sélection de la ligne de bit et de la ligne de mot correspondantes par un circuit de décodage d'adresse de la mémoire.

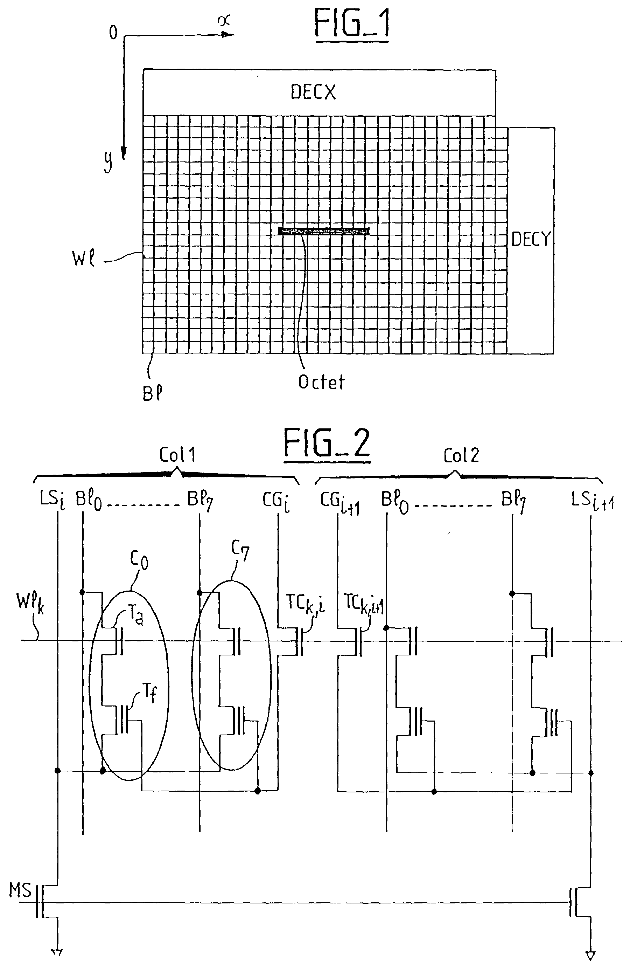

Mais il est aussi habituel de prévoir un accès par mot à la mémoire. Les architectures mémoires courantes prévoient ainsi la possibilité d'accéder simultanément à plusieurs bits, typiquement 8, 16 ou 32. Dans tous les cas, l'unité de base en termes de mot mémoire est l'octet, formé de huit bits. Des architectures mémoires sont ainsi basées sur l'octet, les huit cellules mémoire correspondantes étant situées sur la même ligne de mot. Un schéma simplifié de cette architecture matricielle des mémoires est représenté sur la figure 1. Dans une telle architecture, les lignes de bit B1, pilotées par le décodeur de colonne DECX et qui contactent les drains de transistors MOS, sont des lignes en métal (aluminium). Les lignes de mot Wl pilotées par le décodeur de rangées DECY et qui contactent des grilles de transistors MOS, sont des lignes réalisées en polysilicium. Ces lignes d'interconnexion parcourent tout le plan mémoire, longitudinalement (0y) pour les lignes de bit, horizontalement (0x) pour les lignes de mot.

Dans cette architecture, un octet est formé de huit cellules situées sur une même ligne de mot Wl, à l'intersection de huit lignes de bits consécutives.

Les architectures habituelles de mémoire EEPROM comprennent aussi des lignes de source, en métal, qui contactent les diffusions de source des cellules mémoire, pour tirer ces sources à la masse, en lecture notamment. Ces lignes de source parcourent le plan mémoire longitudinalement. Elles sont habituellement réalisées en métal. Elles sont connectées en périphérie du plan mémoire à un transistor de mise à la masse commandé par un signal de contrôle fonction du mode d'accès à la mémoire.

Pour permettre la sélection simultanée de tous les bits d'un mot d'une ligne de mot, et seulement de ceux-là, à l'organisation matricielle se combine un groupement des lignes de bit en colonnes. Cela permet l'accès simultané à plusieurs cellules, typiquement huit, formant un mot mémoire (octet) . Une telle architecture nécessite des transistors supplémentaires permettant chacun la sélection d'une colonne particulière de la mémoire. Dans ce cas, on prévoit une ligne de contrôle par colonne, c'est à dire, par groupe de huit lignes de bit, avec un transistor de sélection de colonne par ligne de mot. Ces lignes de contrôle parcourent elles aussi le plan mémoire longitudinalement. Elles sont habituellement réalisées en métal.

Dans le cas d'une telle architecture matricielle avec groupement par colonne, on prévoit généralement une ligne de source pour deux colonnes, qui permet de relier les sources des transistors à grille flottante des cellules mémoire de ces deux colonnes, à un transistor correspondant de mise à la masse. Le nombre de ces transistors de mise à la masse dépend typiquement de l'architecture mémoire retenue par le concepteur, selon les contraintes d'application d'une part et des règles de conception et de dessin d'autre part.

Ainsi, un plan mémoire EEPROM comprend habituellement comme lignes d'interconnexion parcourant tout le plan mémoire (dans une dimension de celui-ci), les lignes de bit, les lignes de mot, les lignes de contrôle, et les lignes de source.

Sur la figure 2, on a représenté deux colonnes d'un plan mémoire EEPROM correspondant.

Dans cet exemple, on a représenté les cellules de deux colonnes consécutives, situées sur une même ligne de mot Wl_{k.}

On rappelle qu'une cellule de mémoire EEPROM, comprend habituellement (au moins) un transistor d'accès Ta en série avec un transistor à grille flottante Tf. Le transistor d'accès est connecté sur sa grille à la ligne de mot correspondante, et sur son drain, à la ligne de bit correspondante.

Dans l'exemple, la première colonne Col1 comprend huit cellules C0 à C7 placées sur la ligne de mot Wl_{k.} La première cellule C0 est connectée à la ligne de bit Bl0, la deuxième cellule C1 est connectée à la ligne de bit Bl1, et ainsi de suite jusqu'à la dernière cellule C7 qui est connectée à la ligne de bit Bl7. Tous les transistors à grille flottante de ces cellules C0 à C7 ont une diffusion de source commune, connectée à la ligne de source associée à la colonne, LSᵢ.

Un transistor de sélection de colonne TC_{k,i} est connecté entre la ligne de contrôle CGᵢ associée à la colonne et la grille commune des transistors à grille flottante des cellules C0 à C7.

La deuxième colonne Col2 est de structure identique. Dans l'exemple, elle est réalisée dans le plan mémoire de façon symétrique. Ainsi, de gauche à droite, on trouve la ligne de source LSᵢ de la première colonne, les huit lignes de bit Bl0 à Bl7, la ligne de contrôle CGᵢ de la première colonne, la ligne de contrôle CGᵢ₊₁ de la deuxième colonne, huit lignes de bit Bl0 à Bl7, et la ligne de source LSᵢ₊₁ de cette colonne.

Le problème qui se pose avec de telles architectures mémoire, réside dans les différentes lignes d'interconnexion qui parcourent tout le plan mémoire dans au moins une direction de celui-ci, Ox ou Oy, et qui sont connectées aux cellules.

En effet, il est bien connu que certaines étapes de fabrication d'un circuit intégré engendrent des charges électrostatiques qui sont collectées par les lignes d'interconnexions, qui forment antenne. Ceci peut entraîner une augmentation de potentiel sur ces lignes, qui affectent les éléments qui y sont connectés. Dans l'exemple des lignes d'interconnexion d'une mémoire, ce sont les cellules de cette mémoire qui sont affectées. En effet l'augmentation de potentiel sur des éléments constitutifs des cellules mémoire peut avoir différents effets néfastes.

Un premier effet néfaste est l'endommagement ou la destruction d'éléments actifs de ces cellules :
jonctions, oxyde de grille, oxyde tunnel, qui entraîne des fuites de ces éléments (jonctions, oxyde de grille) ou même le claquage (oxyde tunnel). Ces effets néfastes se retrouvent plus généralement dans tout circuit intégré comprenant des lignes d'interconnexion connectées à des éléments électroniques.

Un autre effet néfaste est la réduction du cycle de vie des cellules mémoire. L'augmentation importante du potentiel sur ces lignes due aux charges électrostatiques peut avoir le même effet qu'un grand nombre d'accès en lecture et/ou écriture, réduisant d'autant la durée de vie garantie pour ces cellules.

Parmi les étapes de fabrication qui posent ces problèmes, on peut notamment citer l'étape de gravure par plasma des couches de polysilicium et de métallisation et les étapes de nettoyage des plaquettes par flux gazeux, ou par liquide.

Dans l'étape de gravure par plasma, la plaquette est soumise à un bombardement d'ions, qui peut entraîner l'augmentation du potentiel en surface. Des précautions particulières sont habituellement prises pour prévenir cette augmentation de potentiel, notamment l'application d'un champ magnétique dans l'enceinte de gravure. Mais ces précautions s'avèrent en pratique insuffisantes.

Dans les étapes de nettoyage des plaquettes, le frottement du fluide de nettoyage peut engendrer des charges électrostatiques, par triboélectricité. L'utilisation connue d'un fluide conducteur ne permet pas de résoudre ce problème de façon satisfaisante.

Dans certains circuits intégrés, on utilise aussi des dispositifs passifs, typiquement des diodes, connectés entre les interconnexions et le substrat pour limiter l'incursion de tension sur ces lignes. L'incursion est ainsi limitée sur la ligne d'interconnexion soit par la mise en direct de la diode, avec une limitation en valeur absolue à 0.6 volt, soit par la mise en avalanche de la diode avec une limitation en valeur absolue à 15 volts (valeurs typiques). Cependant ces dispositifs ne sont pas satisfaisants, notamment parce qu'ils ne peuvent pas être utilisés pour des lignes d'interconnexion amenées à recevoir de forts potentiels en opérationnel, supérieurs aux seuils des diodes comme les lignes d'interconnexion d'un plan mémoire, pour la programmation des cellules.

Ainsi, un objet de l'invention est de résoudre le problème de l'apparition de charges électrostatiques sur des lignes d'interconnexion d'un circuit intégré.

Ce problème d'apparition de charges électrostatiques se pose au long du processus de fabrication du circuit intégré, dès lors que les lignes d'interconnexion et leurs connexions à des éléments du circuit intégré sont réalisées.

L'approche utilisée pour résoudre ce problème n'est pas de prévenir l'apparition de ces charges, comme dans l'état de la technique, mais de trouver un moyen pour écouler les charges qui pourraient être engendrées au long de la fabrication du circuit intégré, sans altérer aucun des éléments connectés à ces lignes d'interconnexion.

L'idée à la base de l'invention est un dispositif de protection actif au long de la fabrication du circuit intégré pour protéger une ligne d'interconnexion.

L'invention concerne donc un dispositif de protection d'une ligne d'interconnexion d'un circuit intégré caractérisé en ce qu'il comprend un dispositif d'écoulement de charges connecté à la ligne d'interconnexion à protéger et une ligne d'interconnexion témoin pour déclencher ledit dispositif d'écoulement, le dispositif de protection étant actif au long de la fabrication du circuit intégré.

En pratique, on peut prévoir une même ligne d'interconnexion témoin connectée à plusieurs dispositifs d'écoulement, permettant la protection d'un ensemble de lignes d'interconnexion.

Pour une bonne efficacité, une même ligne d'interconnexion témoin est connectée à un nombre limité de dispositifs d'écoulement, pour ne pas altérer la sensibilité de la ligne d'interconnexion témoin.

Dans l'exemple d'application à un circuit intégré à mémoire, on pourra notamment placer dans le plan mémoire des lignes d'interconnexion témoins pour protéger les différentes lignes d'interconnexion prévues dans le plan mémoire pour accéder aux cellules.

D'autres caractéristiques et avantages de l'invention sont détaillés dans la description suivante de différents modes de réalisation, présentés à titre indicatif et non limitatif, et en référence aux dessins annexés dans lesquels :
- La figure 1 déjà décrite représente schématiquement un plan mémoire;
- la figure 2 déjà décrite représente de façon plus détaillée, deux octets successifs dans un plan mémoire de type EEPROM;
- la figure 3 représente un dispositif de protection d'une ligne d'interconnexion selon l'invention;
- la figure 4 représente une variante de réalisation d'un dispositif de protection selon l'invention pour un ensemble de lignes d'interconnexion;
- les figures 5a et 5b représentent des exemples d'application du dispositif de protection selon l'invention à la protection de lignes d'interconnexion dans un plan mémoire;
- la ligne 6 représente un autre mode de réalisation de lignes témoins ;
- les figures 7a et 7b représentent chacune une vue en coupe d'un transistor MOS classique utilisable dans un dispositif de protection selon l'invention; et
- la figure 8 représente la vue en coupe d'un transistor MOS dans lequel les contacts sont réalisés en polysilicium, utilisable dans un dispositif de protection selon l'invention.

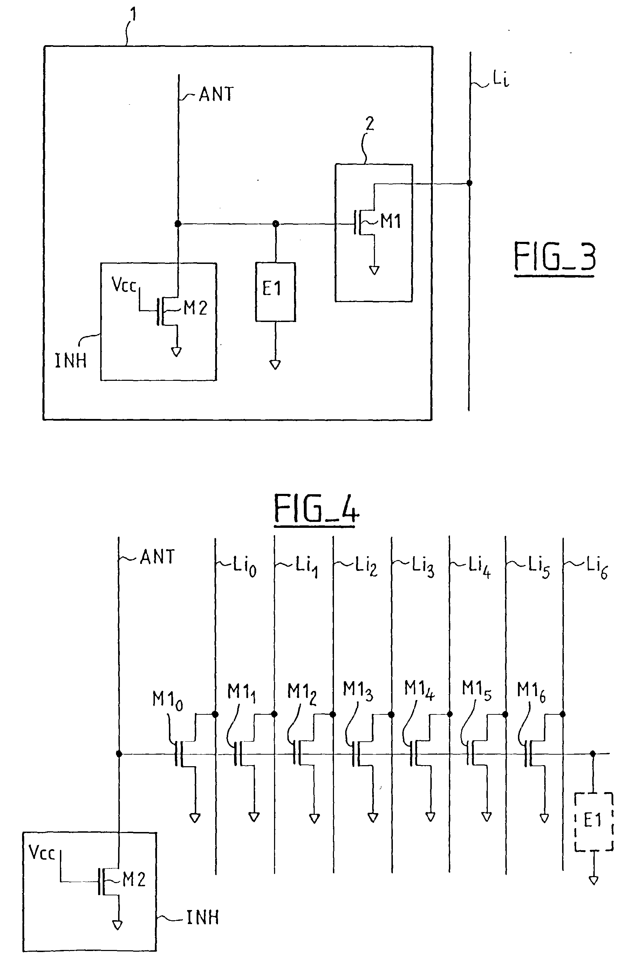

La figure 3 représente un dispositif 1 de protection selon l'invention d'une ligne d'interconnexion Li.

Ce dispositif de protection 1 comprend principalement un dispositif 2 d'écoulement de charges vers le substrat du circuit intégré et une ligne d'interconnexion témoin ANT pour déclencher le dispositif d'écoulement de charges.

Dans l'exemple, le dispositif d'écoulement de charges comprend un transistor MOS M1 de type N connecté entre la ligne d'interconnexion à protéger et le substrat, qui est schématiquement représenté par une flèche vers le bas. Ce transistor MOS M1 est commandé sur sa grille par la ligne d'interconnexion témoin ANT.

Le principe à la base du dispositif de protection, est que si des charges électrostatiques apparaissent sur la ligne d'interconnexion à protéger, dues à l'étape de fabrication du moment, elles apparaissent aussi sur la ligne témoin (et réciproquement). L'apparition de charges sur la ligne témoin entraîne l'augmentation du potentiel sur la grille (la capacité de grille se charge). Lorsque la tension sur la grille devient trop importante, ce transistor devient passant. Il offre alors un passage vers le substrat aux charges électrostatiques qui pourraient apparaître sur la ligne d'interconnexion protégée Li. Ce transistor M1 est dimensionné pour supporter le courant induit par la quantité de charges électrostatiques à écouler.

Le dispositif de protection est amené à assurer sa fonction en cours de fabrication du circuit intégré, alors que le circuit intégré n'est pas alimenté. Le substrat à ce moment n'est donc pas polarisé. Le dispositif de protection selon l'invention est ainsi un dispositif actif, qui tire son énergie des charges électrostatiques elles-mêmes.

Dans un perfectionnement, le dispositif de protection comprend en outre un écrêteur E1, pour limiter la tension sur la ligne d'interconnexion témoin. En effet, il faut que la tension sur la grille du transistor M1 reste inférieure à la tension de claquage de l'oxyde de grille. Cet écrêteur sera par exemple dimensionné pour se déclencher vers 15 volts. Pour la réalisation pratique de cet écrêteur, on utilisera des dispositifs similaires à ceux utilisés pour protéger les plots d'entrée des circuits intégrés, contre les décharges électrostatiques, mais de plus faibles dimensions, la quantité de charges électrostatiques étant moindre dans le domaine de l'invention. Cet écrêteur sera par exemple réalisé, de manière classique, par un transistor bipolaire latéral, ou au moyen d'une simple diode.

Dans l'exemple représenté sur la figure 3, le dispositif de protection comprend en outre un dispositif d'inhibition INH, pour désactiver le dispositif de protection à la mise sous tension du circuit intégré. En effet, en fonctionnement opérationnel, certaines lignes d'interconnexion peuvent être amenées à de forts potentiels, comme par exemple, un potentiel de programmation de cellules mémoire. Il ne faut pas que le dispositif de protection associé à ces lignes d'interconnexion se déclenche en opérationnel. Aussi, au moins pour les lignes d'interconnexion amenées à recevoir de forts potentiels en mode de fonctionnement opérationnel du circuit intégré, prévoit-on un tel dispositif d'inhibition. Ce dispositif d'inhibition est réalisé de façon simple par un transistor Mos M2 de type N dont la grille est connectée à la tension d'alimentation logique du circuit intégré, pour tirer la ligne d'interconnexion témoin à la tension de polarisation du substrat dès la mise sous tension du circuit intégré. De cette façon, le dispositif d'écoulement de charges ne peut plus être activé en mode de fonctionnement opérationnel du circuit intégré. Si le transistor MOS M2 est choisi de type P, sa grille sera connectée à la masse électrique du circuit intégré.

Le transistor M2 du dispositif d'inhibition peut en outre réaliser la fonction de l'écrêteur El, notamment du fait de la structure de transistor bipolaire latéral parasite inhérente à la structure du transistor MOS. Aussi, dans le cas où le dispositif de protection associé à une ligne d'interconnexion comprend un tel dispositif d'inhibition, on n'aura pas besoin de prévoir en plus l'écrêteur, ce qui permet de réaliser une économie de surface dans le circuit intégré.

La figure 4 représente une application du dispositif de protection selon l'invention à un groupe de lignes d'interconnexion Li0 à Li6. Il comprend une antenne ANT, un dispositif d'inhibition INH et/ou un écrêteur E1 (représenté en pointillé) et autant de dispositifs de détection M1₀,..., M1₆ que de lignes d'interconnexion Li0 à Li6 à protéger.

Ainsi, le dispositif de protection selon l'invention permet de protéger une à plusieurs lignes d'interconnexion au moyen d'une ligne d'interconnexion témoin. Il fonctionne dès que cette ligne et les dispositifs d'écoulement associés sont réalisés. Il peut-être désactivé après fabrication du circuit intégré, par le dispositif d'inhibition INH prévu à cet effet, par la mise sous tension du circuit intégré.

En pratique, la ligne d'interconnexion témoin est réalisée à proximité de la ou des lignes d'interconnexion à protéger, pour une efficacité optimum. En effet, si la ligne témoin est trop loin de la ligne à protéger, le dispositif d'écoulement associé pourrait se déclencher trop tard.

Sur les figures 3 et 4, la ligne d'interconnexion témoin est parallèle aux lignes d'interconnexion qu'elle protège, ce qui semble être le mode de réalisation le plus efficace dès lors que la ligne témoin peut-être réalisée à proximité de ces lignes. Cependant on peut prévoir dans certaines structures de circuit intégré, que la ligne témoin ne suive pas la même direction que les lignes qu'elle protège.

Ainsi, la mise en oeuvre de l'invention suppose la prise en compte de l'efficacité de protection désirée et de l'augmentation de surface nécessaire pour l'implantation de ces dispositifs.

Dans une application à la protection de lignes d'interconnexion d'une mémoire, on utilise les symétries existantes dans le schéma d'implantation de la mémoire pour optimiser la protection selon l'invention. Les exemples d'application du dispositif de protection selon l'invention donnés ci-après sont applicables aux mémoires en général, pour la protection des lignes d'interconnexion permettant d'accéder aux cellules (lecture, écriture, rafraîchissement, ....).

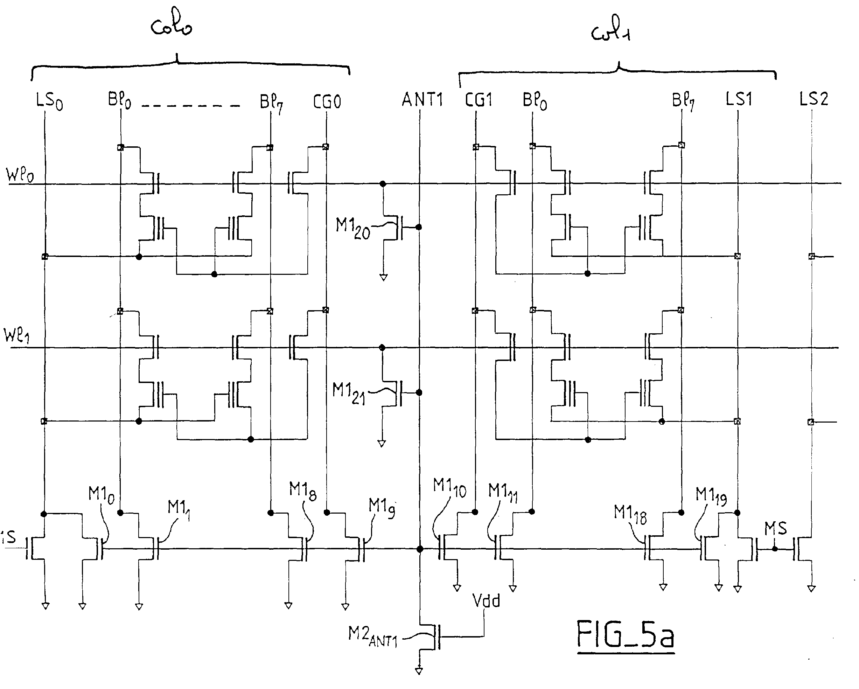

La figure 5a représente ainsi un exemple d'architecture connue de mémoire EEPROM, dans laquelle on a intégré des dispositifs de protection selon l'invention.

Dans un tel plan mémoire, on a vu que les lignes d'interconnexion à protéger sont d'une part les lignes de bit, les lignes de contrôle et les lignes de source, qui parcourent le plan mémoire dans la direction Ox du plan mémoire (c'est à dire longitudinalement) et d'autre part, les lignes de mot, qui parcourent le plan mémoire dans la direction Oy (c'est à dire horizontalement).

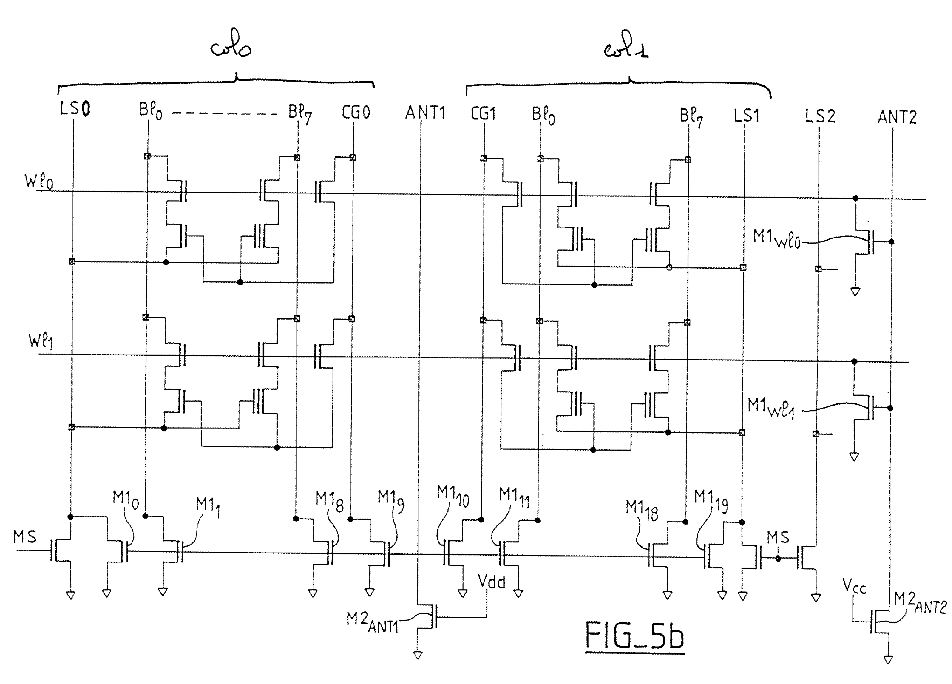

On a déjà décrit un exemple de structure d'un plan mémoire EEPROM (figure 2). Dans cet exemple, on a une ligne de contrôle et une ligne de source par groupe de huit lignes de bit. On a représenté sur la figure 5 deux colonnes successives d'un tel plan mémoire. On a ainsi sur cette figure 5a, de gauche à droite, une première ligne de source, LS0, puis huit lignes de bit, Bl7 à Bl0, puis une ligne de contrôle CG0, ces lignes formant la première colonne Col0 de la mémoire; puis viennent la ligne de contrôle suivante, CG1, huit lignes de bit Bl7 à Bl0, puis la ligne de source suivante LSl, ces lignes formant la deuxième colonne Coll de la mémoire, puis on reprend avec la ligne de bit suivante LS2 et ainsi de suite pour les colonnes suivantes. On dispose ainsi, dans cette architecture d'un axe de symétrie dans chaque paire de colonnes successives, entre les deux lignes de contrôle.

Dans cette architecture, on peut ainsi protéger efficacement les lignes de bit, de contrôle et de source de deux colonnes successives, au moyen d'une seule ligne témoin ANT1, placée entre deux lignes de contrôle qui se suivent, CG0 et CG1 dans l'exemple comme représenté sur la figure 5a. Les dispositifs de protection correspondants et le dispositif d'inhibition sont placés de préférence en périphérie de la mémoire, dans l'exemple, en bas. On a ainsi un dispositif d'écoulement par ligne d'interconnexion protégée par la ligne témoin ANT1, soit dans l'exemple, 20 transistors M1₀ à M1₁₉, pour protéger respectivement la ligne LS0, huit lignes de bit, la ligne CG0, la ligne CG1, huit lignes de bit et la ligne LS1. Le transistor d'inhibition M2_{ANT1} est connecté entre la ligne témoin et le substrat du circuit intégré. Si on prévoit en plus, un écrêteur E1 (représenté en pointillé sur la figure 5a), il est connecté entre la ligne témoin et le substrat.

En ce qui concerne les lignes de mot, on pourrait utiliser les lignes témoins précédentes ANT1 pour les protéger comme représenté sur la figure 5a. On peut ainsi prévoir qu'une antenne ANT1 protège en outre 16 lignes de mot. On aurait ainsi, dans un plan mémoire de 512 lignes de bit par 512 lignes de mot, 32 lignes témoin ANT1, chacune protégeant 16 lignes de bits et les lignes de contrôle et de source associées et 16 lignes de mot. Dans ce cas le dispositif d'écoulement est placé à l'intersection de la ligne de mot et de la ligne témoin associées. Dans l'exemple représenté (FIG.5a) le dispositif d'écoulement comprend ainsi un transistor M1₂₀ connecté entre la ligne de mot Wl0 et le substrat et un transistor M1₂₁ connecté entre la ligne de mot Wll et le substrat.

De préférence, comme représenté sur la figure 5b, pour protéger les lignes de mots, on prévoit des lignes témoins différentes de celles utilisées pour les lignes de bit, de contrôle et de source.

Dans un premier exemple de réalisation correspondante représentée sur la figure 5b, on utilise ainsi une même ligne témoin ANT2 pour protéger les lignes de mot.

Dans cet exemple, cette ligne témoin ANT2 est réalisée en bout de plan mémoire, parallèlement aux lignes de bit, avec un dispositif d'écoulement par ligne de mot, placé en bout de cette ligne de mot. Dans ce cas, chaque dispositif d'écoulement est placé à l'intersection de la ligne de mot associée et de cette ligne témoin ANT2. Sur la figure 5b, on a ainsi un premier transistor d'écoulement M1_{wl0} connecté entre la ligne de mot Wl0 et le substrat et dont la grille est connectée à la ligne témoin ANT2 et un deuxième transistor M1_{Wl1} connecté entre la ligne de mot Wl1 et le substrat et dont la grille est connectée à la ligne témoin ANT2. Le dispositif d'inhibition M2_{ANT2} correspondant est placé en bout de ligne témoin.

La limitation pratique du nombre de lignes de bit protégées par une seule antenne est la perte de sensibilité de l'antenne, due à la charge capacitive équivalente des grilles des transistors des dispositifs d'écoulement.

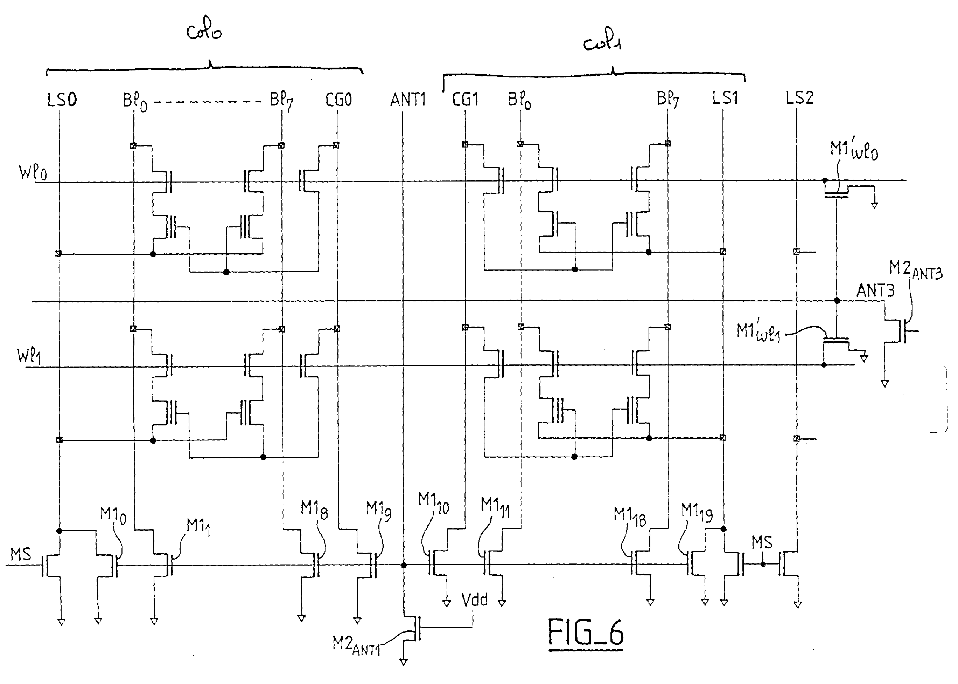

Sur la figure 6, on a représenté un autre mode de réalisation des lignes témoins associées aux lignes de mot. Dans cet exemple, on place une ligne témoin ANT3 entre deux lignes de mot successives Wl0 et Wl1. Cette ligne témoin est donc parallèle à ces lignes. Ainsi, on a une ligne témoin pour deux lignes de mots successives du plan mémoire. Cette réalisation est très efficace mais très coûteuse, puisque pour un plan mémoire de 512 lignes de mot, il nécessite la réalisation de 251 lignes témoin.

Dans cet exemple, les dispositifs d'écoulement et le dispositif d'inhibition sont placés en périphérie du plan mémoire. Sur la figure 6, on a ainsi représenté un premier transistor d'écoulement M1'_{Wl0} connecté entre la ligne de mot Wl0 et le substrat et dont la grille est connectée à la ligne témoin ANT3 et un deuxième transistor M1'_{Wl1} connecté entre la ligne de mot Wl1 et le substrat et dont la grille est connectée à la ligne témoin ANT3. Le dispositif d'inhibition M2_{ANT3} correspondant est placé en bout de ligne témoin ANT3.

Il existe bien d'autres exemples de réalisation, plus ou moins efficaces et plus ou moins coûteux en place. Le choix de l'une ou l'autre réalisation dépend en pratique des contraintes liées à l'application concernée.

Cependant, une autre considération, qui concerne la fabrication du dispositif de protection est à prendre en compte pour la mise en oeuvre de l'invention.

En effet, pour que le dispositif de protection associé à une ou plusieurs lignes de bit soit efficace dès la fabrication de ces lignes, il faut que le dispositif de protection soit réalisé au plus tard dans l'étape de fabrication des lignes qu'il protège.

Or toutes les lignes d'interconnexion d'un circuit intégré ne sont pas réalisées dans le même matériau. Dans l'exemple de la mémoire EEPROM, les lignes de mot sont en polysilicium, tandis que les lignes de bit, de source et de contrôle sont en métal. Or les couches de polysilicium sont réalisées avant les couches de métal. Si on prend l'exemple de réalisation représenté en figure 5a, si l'antenne ANT1 est réalisée en métal et est utilisée comme ligne témoin des lignes de mot Wl0 et Wl1 (cas représenté avec les transistors M1₂₀ et M1₂₁ d'écoulement associés), les lignes de polysilicium ne sont pas protégées entre l'étape de gravure du polysilicium où elles sont réalisées et l'étape de gravure du métal où la ligne témoin est réalisée.

Ainsi, il est préférable que les lignes d'interconnexion à protéger et les lignes témoins associées forment des ensembles homogènes.

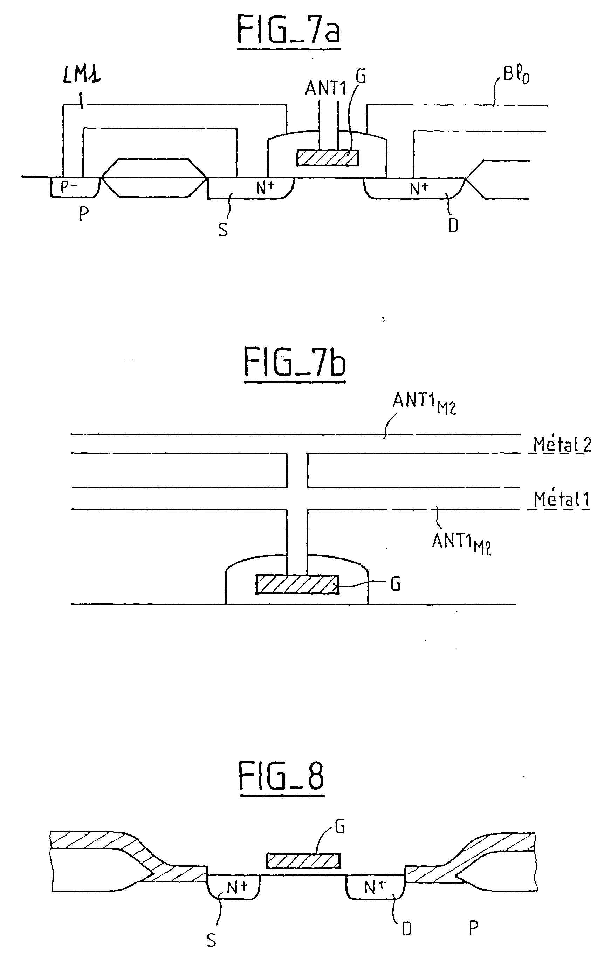

On prévoit ainsi de protéger les lignes de bit, de contrôle et de source, qui sont en métal, par des lignes témoins en métal. Ceci ne pose pas de difficultés de fabrication particulières, puisque pour la réalisation de l'ensemble du ou des dispositifs de protection (lignes témoins, transistors, diodes d'écrêtage), on utilise les technologies et techniques de connexion classiques. Sur la figure 7a, on a ainsi représenté en coupe un transistor MOS qui peut être utilisé comme transistor dans les dispositifs d'écoulement ou dans les dispositifs d'inhibition. Dans l'exemple, la diffusion de source S du transistor est connectée par une ligne en métal LM1 à une prise de substrat (diffusion P⁻ dans l'exemple). La diffusion de drain D est connectée par une ligne métal, qui peut-être une ligne de bit Bl0. La grille en polysilicium est connectée à une ligne en métal, qui dans l'exemple, est la ligne témoin ANT1.

Ainsi, lorsque l'étape de gravure du métal est terminée, le dispositif de protection est opérationnel pour protéger des lignes qui sont réalisées dans cette même étape. On a alors une efficacité optimum de protection de ces lignes.

Dans le cas de technologies à double niveau de métal, notés Métal1 et Métal2, on prévoit de réaliser de préférence les lignes témoins sur le même niveau de métal que les lignes qu'elle protège.

Si par exemple, les lignes de bit sont réalisées en Métal1 et les lignes de source et de contrôle en Métal2, on prévoit alors de dédoubler la ligne témoin ANT1, pour en faire une en métall, pour protéger les lignes de bit dès leur fabrication et une en Métal2, pour protéger les lignes de contrôle et de source, les deux lignes témoins utilisant les mêmes dispositifs d'écoulement et d'inhibition. Il suffit par exemple de court-circuiter ces deux lignes témoins, comme représenté dans la vue en coupe de la figure 7b, sur laquelle on a représenté les deux niveaux de métal de la ligne témoin, ANT1_{M1} et ANT_{M2}, et leurs connexions sur la grille G d'un même transistor d'écoulement.

D'une manière plus générale, qui ne se limite pas aux niveaux de métal, lorsque des lignes d'interconnexion sont réalisées dans le même matériau, mais dans différents niveaux dans le circuit intégré, on peut prévoir de démultiplier la ligne témoin réalisée dans ce matériau, en sorte que l'on obtient plusieurs lignes de ce matériau, les unes au-dessus des autres, court-circuitées pour partager les mêmes dispositifs d'écoulement. De cette façon, au fur et à mesure de la réalisation des différents niveaux, on a toujours une efficacité de protection optimum.

Dans l'exemple de la mémoire EEPROM, les lignes de mot sont réalisées en polysilicium. On prévoit donc, de préférence, de réaliser les lignes témoins associées, en polysilicium également. Cependant, cela ne suffit pas à rendre le dispositif de protection opérationnel dès l'étape de fabrication correspondante terminée. En effet, les contacts sur les transistors sont habituellement réalisés en métal, comme représenté sur les figures 7a et 7b. Dans le cas présent, il faut réaliser ces contacts différemment, pour que ces connexions soient opérationnelles dès l'étape de fabrication considérée terminée, c'est à dire l'étape de gravure du polysilicium. Sur la figure 8, on a représenté une technique de connexion bien connue, dite de contact enterré, qui est peut-être utilisée.

Dans cette technique, le contact des sources et drains est réalisé par des lignes en polysilicium. Le contact est réalisé par la tranche du drain (ou de la source), avec le polysilicium déposé en surface du substrat, le recuit du polysilicium entraînant la formation d'une diode entre le polysilicium et le substrat par diffusion du dopage de polysilicium dans le substrat.

En utilisant cette technique pour réaliser au moins les transistors d'écoulement de charge associés aux lignes témoins en polysilicium, le dispositif de protection est opérationnel dès l'étape de gravure du polysilicium. Il n'est pas utile d'utiliser cette technique pour les transistors d'inhibition, car ces transistors n'ont à être opérationnels que lorsque le circuit intégré est terminé et mis sous tension. On peut donc utiliser des transistors MOS classiques, moins coûteux en place.

On notera que dans certaines architectures mémoire, on peut avoir plusieurs niveaux de polysilicium. On peut alors démultiplier les lignes témoins comme indiqué précédemment.

La technique de connexion par contact enterré est notamment utilisable dans les exemples de réalisation décrits, avec la ligne témoin ANT2 (figure 5b) et la ligne témoin ANT3 (figure 6).

D'autres variantes de réalisation sont possibles qui peuvent dépendre de la technologie et de l'architecture du circuit intégré considéré.

Toutes ces variantes restent du domaine de l'invention. En particulier, l'invention ne se limite pas à une application à des plans mémoire. Elle s'applique plus généralement à tout circuit intégré comportant des lignes d'interconnexion d'éléments électroniques.

## Revendications

1. Dispositif de protection (1) d'une ligne d'interconnexion (Li) d'un circuit intégré, caractérisé en qu'il comprend un dispositif d'écoulement de charges (M1) connecté entre la ligne d'interconnexion à protéger et le substrat du circuit intégré et une ligne d'interconnexion témoin (ANT) pour déclencher ledit dispositif d'écoulement, le dispositif de protection étant actif au long de la fabrication du circuit intégré.

2. Dispositif de protection selon la revendication 1, caractérisé en ce que la dite ligne d'interconnexion témoin (ANT) est commune à un ensemble de lignes d'interconnexion à protéger (Li0 à Li6), un dispositif d'écoulement de charges (M1₀ à M1₆) étant connecté entre chacune des lignes à protéger et le substrat.

3. Dispositif de protection selon la revendication 2, caractérisé en ce que ledit ensemble de lignes d'interconnexion et la ligne témoin associée sont réalisés dans le même matériau.

4. Dispositif de protection selon l'une des revendications précédentes, caractérisé en ce que la ou les lignes d'interconnexion et la ligne témoin associée sont réalisées dans la même étape de fabrication.

5. Dispositif de protection selon la revendication 3 en combinaison avec la revendication 4,
caractérisé en ce que la ligne d'interconnexion témoin (ANT1) est démultipliée en autant de lignes (ANT_{M1}, ANT_{M2}) que de niveaux de fabrication (Métal1, Métal2) des lignes d'interconnexion.

6. Dispositif de protection selon l'une quelconque des revendications précédentes, caractérisé en ce qu'il comprend un circuit d'inhibition (INH) connecté entre la ligne d'interconnexion témoin (ANT) et le substrat, et en ce que ce circuit d'inhibition est activé par la mise sous tension du circuit intégré.

7. Dispositif de protection selon l'une quelconque des revendications précédentes, caractérisé en ce qu'il comprend en outre un écrêteur de tension (E1) connecté entre la ligne d'interconnexion témoin (ANT) et le substrat.

8. Dispositif de protection selon l'une quelconque des revendications précédentes, caractérisé en ce qu'il est utilisé pour protéger des lignes d'interconnexion (Bl0, CG0, LS0, Wl0) d'un plan mémoire.

9. Plan mémoire caractérisé en ce qu'il comprend au moins un dispositif de protection selon la revendication 8, pour protéger les lignes d'interconnexion permettant l'accès aux cellules mémoire.

10. Plan mémoire selon la revendication 9, organisé matriciellement en lignes de bit et lignes de mot et selon une architecture colonne, comprenant des lignes de bit (Bl0,..., Bl7), une ligne de source (LS1) et une ligne de contrôle (CG0) par colonne (Col0), caractérisé en ce qu'un même dispositif de protection est utilisé pour protéger au moins les lignes de bit, la ligne de source et la ligne de contrôle d'une même colonne, comprenant une ligne témoin (ANT1) et un dispositif d'écoulement par ligne d'interconnexion protégée.

11. Plan mémoire selon la revendication 10, caractérisé en ce qu'il comprend un dispositif de protection par deux colonnes successives, la ligne d'interconnexion témoin (ANT1) commune à deux colonnes successives (Col0, Col1) étant géographiquement placée entre ces deux colonnes pour protéger les lignes d'interconnexion correspondantes.

12. Plan mémoire selon la revendication 10 ou 11, caractérisé en ce que le dispositif de protection des lignes de bit, des sources et de contrôle est utilisé pour protéger des lignes de mot du plan mémoire, avec un dispositif d'écoulement de charges (M1₂₀, M1₂₁) pour chaque ligne de mot protégée.

13. Plan mémoire selon la revendication 10 ou 11, les lignes de bit, de contrôle et de source étant réalisées en métal, caractérisé en ce que la ligne d'interconnexion témoin (ANT1) est en métal.

14. Plan mémoire selon la revendication 13, caractérisé en ce que ladite ligne d'interconnexion témoin (ANT1) est démultipliée en autant de lignes (ANT1_{M1}, ANT1_{M2}) que de niveaux de métal parmi les lignes d'interconnexion protégées.

15. Plan mémoire selon l'une quelconque des revendications 9 à 11, caractérisé en ce qu'il comprend un dispositif de protection par deux lignes de mot successives (Wl0, Wl1), comprenant une ligne d'interconnexion témoin (ANT3) placée entre ces deux lignes de mot.

16. Plan mémoire selon l'une quelconque des revendications 9 à 11, caractérisé en ce qu'il comprend un dispositif de protection pour l'ensemble des lignes de mot du plan mémoire, comprenant une ligne d'interconnexion témoin (ANT2) placée en bout de plan mémoire.

17. Plan mémoire selon la revendication 15 ou 16, les lignes de mot étant en polysilicium, caractérisé en ce que la ligne d'interconnexion témoin correspondante (ANT2, ANT3) est en polysilicium.

18. Plan mémoire selon l'une quelconque des revendications 10, 11 ou 13 à 17, caractérisé en ce que les dispositifs d'écoulement de charge des dispositifs de protection sont réalisés en périphérie du plan mémoire.

19. Plan mémoire selon l'une quelconque des revendications 10 et 12, chacun des dispositifs de protection ayant sa ligne d'interconnexion témoin (ANT1, ANT2, ANT3) connectée à un dispositif d'inhibition (M2_{ANT1}, M2_{ANT2}, M2_{ANT3}), selon la revendication 6, caractérisé en ce que le ou les dispositifs d'inhibition sont réalisés en périphérie du plan mémoire.

20. Circuit intégré comprenant un dispositif de protection ou un plan mémoire selon l'une quelconque des revendications précédentes.
